(19)

Europäisches
Patentamt
European
Patent Office
Office européen
des brevets

(11) **EP 2 541 267 A1**

(12) **EUROPEAN PATENT APPLICATION**
published in accordance with Art. 153(4) EPC

(43) Date of publication:
**02.01.2013 Bulletin 2013/01**

(51) Int Cl.:
**G01R 31/36** (2006.01)

(21) Application number: **11747049.2**

(22) Date of filing: **23.02.2011**

(86) International application number:
**PCT/JP2011/001043**

(87) International publication number:
**WO 2011/105081 (01.09.2011 Gazette 2011/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.02.2010 JP 2010038350**

(71) Applicant: **Panasonic Corporation
Kadoma-shi
Osaka 571-8501 (JP)**

(72) Inventor: **TOKAWA, Osatoshi
2-1-61, Shiromi, Chuo-ku, Osaka 540-6207 (JP)**

(74) Representative: **Grünecker, Kinkeldey,
Stockmair & Schwanhäusser
Leopoldstrasse 4
80802 München (DE)**

(54) **ELECTRONIC DEVICE**

(57)     An object is to prevent a user from having a feeling of strangeness that the battery is running down too quickly in a remaining capacity indication indicated in multiple stages such as percentages.

A microprocessor 406 changes a weight for remaining capacity per a single stage of a remaining battery indication with respect to an actual remaining battery capacity, whereby the feeling of strangeness regarding the reduction of battery capacity can be prevented.

FIG. 1

**Description**

**Technical Field**

The present invention relates to an electronic device, such as a mobile terminal and a cellular phone, having a remaining battery power indication function.

**Background Art**

Recently, a cellular phone is sophisticated, which has a camera function, an Internet browsing function, a game function, etc., in addition to a phone call function. In association with the sophistication, the users hope to grasp information about how much battery capacity still remains in more detail, and a demand for a multistage indication for remaining battery capacity is grown. Patent Document 1 describes an example of the multistage indication. Fig. 5 shows a related-art remaining battery power indication method described in the patent document. In Fig. 5, a display panel 502 includes means for indicating a rough remaining power value 503, bar indicators 504, and a battery symbol 501.

**Related Art Documents**

**Patent Documents**

Patent Document 1: JP-U-3152832
Patent Document 2: JP-A-2008-139070
Patent Document 3: JP-B-2597858

**Summary of the Invention**

**Problem to be Solved by the Invention**

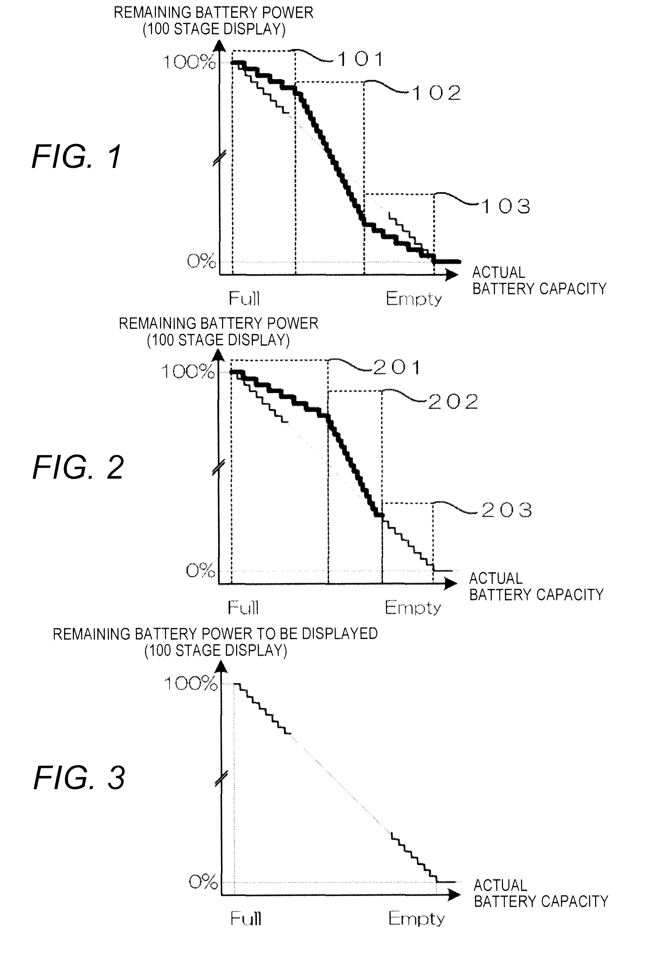

However, in the related-art configuration, the rough remaining power value 503 and the bar indictors 504 are values resultant of equal division of actual remaining battery capacity. In case of a more detailed indication such as a percentage (Fig. 3), the number of times an indication is updated dramatically increases. In particular, when remaining battery power is in a nearly fully charged state, the dramatic increase raises a problem of the user having a feeling of strangeness that the battery is running down too quickly in a remaining capacity indication.

**Means for Solving the Problem**

An electronic device of the present invention includes: a battery configured to supply electric power; a display unit configured to continually display remaining battery capacity based on battery capacity; a plurality of regions provided regarding the remaining capacity indication; and a plurality of continual functions corresponding to the respective regions, wherein proportional constants of the remaining capacity indication corresponding to the battery capacities of the respective regions are changed by the corresponding functions.

With this configuration, remaining battery capacity to be displayed is calculated through use of a corresponding function for each region. Consequently, for example, when the electronic device is in a constant current load state as a result of continuation of the same state of use, time for decreasing remaining battery power can be changed to a longer or shorter period for each region.

In the electronic device of the present invention, the proportional constant to be changed is represented by a weight per a single stage of the remaining capacity indication.

In the electronic device of the present invention, the battery is a rechargeable secondary battery.

In the electronic device of the present invention, the remaining capacity indication is displayed as a percentage.

With the configurations, battery capacity per the single stage of the remaining battery power indication is specified through use of the function, whereby the single stage of the remaining battery power indication, for example, battery capacity corresponding to 1 % in the case of a percentage indication, can be specified for each region.

In the electronic device of the present invention, the plurality of functions are linear functions.

With this configuration, remaining battery power is divided into regions, and a linear function is adopted as the function for calculating remaining battery power for each region. As a result, a continual remaining battery power indication can be displayed by combination of the linear functions.

Further, in the electronic device of the present invention, the plurality of regions include a first region, a second region, and a third region arranged in a direction from 100 % to 0 % of battery capacity; the proportional constant is greater than one in the first region; the proportional constant is smaller than one in the second region; and the proportional constant is greater than one in the third region.

In the electronic device of the present invention, the first region is assigned to a range from 100 % to 70 % of battery capacity; the second region is assigned to a range from 70 % to 40 % of battery capacity; and the third region is assigned to a range from 40 % to 0 %.

With this configuration, a proportional constant of remaining battery power is specified for each region by the above-described configuration. Consequently, for example, when the electronic device is in a constant current load as a result of continuation of the same state of use, the period of indication per the single stage of the remaining battery power indication can be prolonged in the vicinity of a fully charged region or the region of 100 % to 70 %, the period of indication per the single stage of the remaining battery power indication can be shortened in a region of about half of remaining battery power or the region of 70 % to 40 %, and the period of indication per the single stage of the remaining battery power indication can be prolonged in the vicinity of an empty region or the region of 40 % too 0 %.

In the electronic device of the present invention, the plurality of regions include a first region, a second region, and a third region arranged in a direction from 100 % to 0 % of battery capacity; the proportional constant is greater than one in the first region; the proportional constant is smaller than one in the second region; and the proportional constant is substantially equal to one in the third region.

In the electronic device of the present invention, the first region is assigned to a range from 100 % to 45 % of battery capacity; the second region is assigned to a range from 45 % to 20 % of battery capacity; and the third region is assigned to a range from 20 % to 0 % of battery capacity.

With this configuration, a proportional constant of remaining battery power is specified for each region by the above-described configuration. Consequently, for example, when the electronic device is in a constant current load as a result of continuation of the same state of use, the period of indication per the single stage of the remaining battery power indication can be prolonged in the vicinity of the fully charged region or a region of 100 % to 45 %, the period of indication per the single stage of the remaining battery power indication can be shortened in the region of about half remaining battery power or a region of 45 % to 20 %, and wherein the period of indication per the single stage of the remaining battery power indication can be made equal to a period of time during which actual remaining battery power discharges, in the vicinity of the empty region or a region of 20 % to 0 %.

In the electronic device of the present invention, by use of the plurality of proportional constants, the battery capacity in a fully charged state matches the remaining capacity indication, and also the battery capacity in an empty state at which the electronic device can not operate matches the remaining capacity indication.

With the configuration, a region where battery capacity per the single stage of the remaining battery power indication is large is combined with a region where battery capacity per the single stage of the remaining battery power indication is small, whereby remaining battery power can be indicated without changing total battery capacity that can be actually used.

## Advantages of the Invention

As described above, according to the present invention, in a remaining capacity indication indicated in multiple stages such as percentages, a weight for remaining capacity per the single stage of the indication is changed by the continual combination of the functions specified for respective regions. Consequently, the present invention has an advantage in which the feeling of strangeness of the user can be prevented.

## Brief Description of the Drawings

Fig. 1 is a diagram showing changes in remaining battery power of a first embodiment of the present invention.
Fig. 2 is a diagram showing changes in remaining battery power of a second embodiment of the present invention.
Fig. 3 is a diagram showing a change in remaining battery power in the related art.
Fig. 4 is a block diagram of a main portion for explaining the configuration according to the first and second embodiments of the present invention.
Fig. 5 is a diagram showing a remaining battery power indication in the related art.

## Mode for Carrying Out the invention

Embodiments of the present invention are hereinafter described with reference to the drawings.

(First Embodiment)

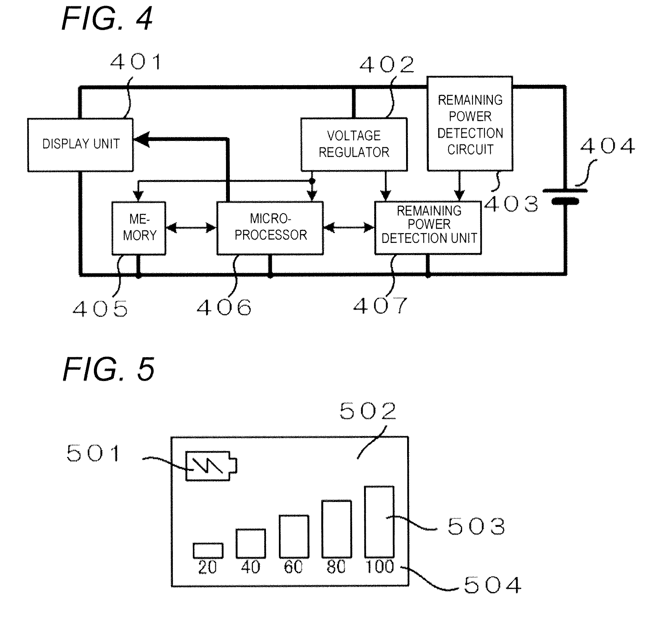

Fig. 4 shows a configuration of a main portion of an embodiment of an electronic device of the present invention. The electronic device includes a display unit 401, a voltage regulator 402, a remaining power detection circuit 403, a battery 404, memory 405, a microprocessor 406, and a remaining power detection unit 407.

In the electronic device including the battery 404 configured to supply electric power and the display unit 401 configured to display remaining battery capacity, the microprocessor 406 receives actual remaining battery capacity as a percentage, which is calculated by the remaining power detection circuit 403 and the remaining power detection unit 407.

Alternatively, the microprocessor 406 may receive an actual total battery capacity value and an actual remaining battery capacity value, and convert the values into percentages.

Remaining capacity to be displayed on the display unit 401 is changed by a proportional constant with respect to the actual remaining battery capacity received by the microprocessor 406. The microprocessor 406 specifies a proportional constant for remaining battery capacity based on a function for each region stored in a storage device such as the memory 405.

Here, the proportional constant for battery capacity per one stage obtained by equally dividing actual battery capacity into 100 stages is defined as one. When the proportional constant is greater than one, battery capacity per a single stage of the remaining capacity indication becomes greater than the battery capacity per one stage of the equally-divided 100 stages. As a result, usage time for the one stage is prolonged. In contrast, when the proportional constant is smaller than one, the battery capacity per the single stage of the remaining capacity indication becomes smaller than the battery capacity the one stage of the equally-divided 100 stages. As a result, the usage time for the one stage is shortened. Accordingly, a weight is assigned to the battery capacity to be displayed by use of the proportional constant.

The battery is a rechargeable secondary battery. Remaining capacity to be displayed on the display unit 401 is represented by a weight per the single stage for each region by the proportional constant regardless of a state of charge or discharge of the battery.

With reference to Fig. 1, means for specifying actual remaining battery capacity is described.
Fig. 1 shows a relationship between actual battery capacity (represented by a horizontal axis) and battery capacity (represented by a vertical axis) to be displayed on the display unit, in which there are a region 101 for Function 1, a region 102 for Function 2, and a region 103 for Function 3.

In an embodiment shown in Fig. 1, an area from a fully charged state to an empty state at which a system can not operate is divided into three regions, i.e., the region 101, the region 102, and the region 103. A function is specified for each region, thereby preventing the feeling of strangeness for battery reduction.

More specifically, weights are specified such that the proportional constant of the region 101 of Function 1 is greater than one the proportional constant of the region 102 of Function 2 is smaller than one, and the proportional constant of Function 3 is greater than one.

In Fig. 1, the remaining battery capacity indication in the region 101 of Function 1 assigned to a range of actual remaining battery capacity from 100 % to about 73 % is represented as follows:

when (actual battery capacity) mod 2 = 0,

$$100 - \{(100 - \text{actual battery capacity}) / 2\}$$

when (actual battery capacity) mod 2 = 1,

$$100 - \{(100 - \text{actual battery capacity}) \times 2 - 1\}$$

The remaining battery capacity indication in the region 102 of Function 2 assigned to a range of actual remaining battery capacity from 73 % to about 40 % is represented as follows:

$$\text{actual battery capacity} \times 2 - 60$$

The remaining battery capacity indication in the region 103 of Function 3 assigned to a range of actual remaining battery capacity from about 40 % to about 0 % is represented as follows:

when (actual battery capacity) mod 2 = 0,

$$20 - \{(40 - \text{actual battery capacity}) / 2\}$$

when (actual battery capacity) mod 2 = 1,

$$20 - \{(40 - \text{actual battery capacity}) \times 2 - 1\}$$

The remaining battery capacity indication is realized by combination of these functions.

More specifically, in a case where the battery has 1000 mAh of actual battery capacity when fully charged and where remaining battery capacity is displayed as percentages, a remaining battery capacity indication is decremented by 1 % as actual battery capacity is consumed by 10 mAh. In contrast, in the present embodiment, when the battery capacity is consumed by 20 mAh within a range of the actual battery capacity from 100 % to 73.5 %, the remaining battery capacity is decremented by 1 %, whereby the remaining capacity indication provides an indication of 100 % to 86 %. Thus, a decrease in remaining capacity can be made slow in the region 101 of Function 1. Similarly, when the battery capacity is consumed by 5 mAh within a range of the actual battery capacity from 73.5 % to 40 %, the remaining battery capacity is decremented by 1 %, whereby the remaining capacity indication provides an indication of 86 % to 20 %. A decrease in remaining capacity can thus be made slow in the region 102 of Function 2. Moreover, when the battery capacity is consumed by 20 mAh within a range of the actual battery capacity from 40 % to 0 %, the remaining battery capacity is decremented by 1 %, whereby the remaining capacity indication provides an indication of 20 % to 0 %. A decrease in remaining capacity can be made slow in the region 103 of Function 3.

By the combination of the functions, a total sum of battery capacity of 270 mAh for 14 stages from 100 % to 86 %, battery capacity of 330 mAh for 33 stages from 86 % to 20 %, and battery capacity of 400 mAh for 40 stages from 20 % to 0 % can be made equal to actual battery capacity of 1000 mAh.

(Second Embodiment)

Fig. 2 is a diagram showing changes in remaining battery capacity of a second embodiment of the present invention. Fig. 2 shows a relationship between actual battery capacity (represented by a horizontal axis) and battery capacity (represented by a vertical axis) to be displayed on the display unit, in which there are a region 201 for Function 4, a region 202 for Function 5, and a region 203 for Function 6. The second embodiment can be executed by the same configuration as that shown in Fig. 4, and means for specifying actual remaining battery capacity is described with reference to Fig. 2.

In the embodiment shown in Fig. 2, weights are specified such that a proportional constant of the region 201 of Function 4 is greater than one, a proportional constant of the region 202 of Function 5 is smaller than one, and a proportional constant of Function 6 is equal to one.

In Fig. 2, the remaining battery capacity indication in the region 201 of Function 4 assigned to a range of actual remaining battery capacity from 100 % to about 47 % is represented as follows:

when (actual battery capacity) mod 2 = 0,

$$100 - \{(100 - \text{actual battery capacity}) / 2\}$$

when (actual battery capacity) mod 2 = 1,

$$100 - \{(100 - \text{actual battery capacity}) \times 2 - 1\}$$

The remaining battery capacity indication in the region 202 of Function 5 assigned to a range of actual remaining battery capacity from 47 % to about 20 % is represented as follows:

$$\text{actual battery capacity} \times 2 - 20$$

The remaining battery capacity indication in the region 203 of Function 5 assigned to actual remaining battery capacity from about 20 % to about 0 % is represented as follows:

$$\text{actual battery capacity} = \text{remaining battery capacity}$$

The remaining battery capacity indication is realized by combination of these functions.

More specifically, in a case where the battery has 1000 mAh of actual battery capacity when fully charged and where remaining battery capacity is indicated as percentages, a remaining battery capacity indication is decremented by 1 % as actual battery capacity is consumed by 10 mAh. In contrast, in the present embodiment, when the battery capacity is consumed by 20 mAh within a range of the actual battery capacity from 100 % to 47.5 %, the remaining battery capacity is decremented by 1 %, whereby the remaining capacity indication provides an indication of 100 % to 74 %. Thus, a decrease in remaining capacity can be made slow in the region 201 of Function 4. Similarly, when the battery capacity is consumed by 5 mAh within a range of the actual battery capacity from 47.5 % to 20 %, the remaining battery capacity is decremented by 1 %, whereby the remaining capacity indication provides an indication of 47 % to 20 %. A decrease in remaining capacity can thus be made slow in the region 202 of Function 5. Moreover, when the battery capacity is consumed by 10 mAh within a range of the actual battery capacity from 20 % to 0 %, the remaining battery capacity is decremented by 1 %, whereby the remaining capacity indication provides an indication of 20 % to 0 %. In the region 203 of Function 6, a decrease in remaining capacity can be made equal to a decrement in actual battery capacity.

By the combination of the functions, a total sum of battery capacity of 520 mAh for 26 stages from 100 % to 74 %, battery capacity of 280 mAh for 54 stages from 74 % to 20 %, and battery capacity of 200 mAh for 20 stages from 20 % to 0 % can be made equal to actual battery capacity of 1000 mAh.

The present invention is intended for various changes or applications executed by a person having ordinary skill in the art based on the description of the specification and well known techniques without departing from the scope of the present invention, and the changes or applications shall fall within a scope for which protection is sought. Moreover, the components described in the embodiments may be combined with one another without departing from the scope of the invention.

The present patent application is based on Japanese Patent Application (Application No. 2010-038350) filed on February 24, 2010, the entire contents of which are incorporated herein by reference.

## Industrial Applicability

The electronic device having the remaining battery indication function of the present invention can specify battery capacity per stage of the indication, and is useful for applications such as cellular phones capable of avoiding user's feeling of strangeness of battery reduction.

## Description of Reference Signs

101   REGION OF FUNCTION 1
102   REGION OF FUNCTION 2
103   REGION OF FUNCTION 3
201   REGION OF FUNCTION 4
202   REGION OF FUNCTION 5
203   REGION OF FUNCTION 6
401   DISPLAY UNIT
402   VOLTAGE REGULATOR
403   REMAINING POWER DETECTION CIRCUIT
404   BATTERY
405   MEMORY
406   MICROPROCESSOR
407   REMAINING POWER DETECTION UNIT

**Claims**

1. An electronic device comprising:

   a battery configured to supply electric power;
   a display unit configured to continually display remaining battery capacity based on battery capacity;
   a plurality of regions provided regarding the remaining capacity indication; and
   a plurality of continual functions corresponding to the respective regions,
   wherein proportional constants of the remaining capacity indication corresponding to the battery capacities of the respective regions are changed by the corresponding functions.

2. The electronic device according to claim 1,
   wherein the proportional constant to be changed is represented by a weight per a single stage of the remaining capacity indication.

3. The electronic device according to claim 1 or 2,
   wherein the battery is a rechargeable secondary battery.

4. The electronic device according to any one of claims 1 to 3,
   wherein the remaining capacity indication is displayed as a percentage.

5. The electronic device according to any one of claims 1 to 4,
   wherein the plurality of functions are linear functions.

6. The electronic device according to any one of claims 1 to 5,
   wherein the plurality of regions comprise a first region, a second region, and a third region arranged in a direction from 100 % to 0 % of battery capacity,
   wherein the proportional constant is greater than one in the first region,
   wherein the proportional constant is smaller than one in the second region, and
   wherein the proportional constant is made greater than one in the third region.

7. The electronic device according to claim 6,
   wherein the first region is assigned to a range from 100 % to 70 % of battery capacity,
   wherein the second region is assigned to a range from 70 % to 40 % of battery capacity, and
   wherein the third region is assigned to a range from 40 % to 0 %.

8. The electronic device according to any one of claims 1 to 5,
   wherein the plurality of regions comprise a first region, a second region, and a third region arranged in a direction from 100 % to 0 % of battery capacity,
   wherein the proportional constant is greater than one in the first region,
   wherein the proportional constant is smaller than one in the second region, and
   wherein the proportional constant is substantially equal to one in the third region.

9. The electronic device according to claim 8,
   wherein the first region is assigned to a range from 100 % to 45 % of battery capacity;
   wherein the second region is assigned to a range from 45 % to 20 % of battery capacity; and
   wherein the third region is assigned to a range from 20 % to 0 % of battery capacity.

10. The electronic device according to any one of claims 1 to 9,
    wherein by use of the plurality of proportional constants, the battery capacity in a fully charged state matches the remaining capacity indication, and also the battery capacity in an empty state at which the electronic device can not operate matches the remaining capacity indication.

REMAINING BATTERY POWER
(100 STAGE DISPLAY)

FIG. 1

100%

~101

~102

~103

0%

Full          Empty          ACTUAL
BATTERY CAPACITY

REMAINING BATTERY POWER
(100 STAGE DISPLAY)

FIG. 2

100%

~201

~202

~203

0%

Full          Empty          ACTUAL
BATTERY CAPACITY

REMAINING BATTERY POWER TO BE DISPLAYED
(100 STAGE DISPLAY)

FIG. 3

100%

0%

Full          Empty          ACTUAL
BATTERY CAPACITY

# FIG. 4

401 — DISPLAY UNIT
402 — VOLTAGE REGULATOR
403 — REMAINING POWER DETECTION CIRCUIT
404
405 — ME-MORY
406 — MICRO-PROCESSOR
407 — REMAINING POWER DETECTION UNIT

# FIG. 5

501
502
503
504

20  40  60  80  100

| INTERNATIONAL SEARCH REPORT | International application No. |
|---|---|
| | PCT/JP2011/001043 |

**A. CLASSIFICATION OF SUBJECT MATTER**
*G01R31/36(2006.01)i*

According to International Patent Classification (IPC) or to both national classification and IPC

**B. FIELDS SEARCHED**

Minimum documentation searched (classification system followed by classification symbols)
G01R31/36

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 5-80135 A (Matsushita Electric Industrial Co., Ltd.), 02 April 1993 (02.04.1993), entire text; all drawings (Family: none) | 1-10 |
| A | Microfilm of the specification and drawings annexed to the request of Japanese Utility Model Application No. 188710/1987(Laid-open No. 92064/1989) (Akira OGAWA), 16 June 1989 (16.06.1989), entire text; all drawings & US 4910103 A | 1-10 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 May, 2011 (13.05.11) | 24 May, 2011 (24.05.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

EP 2 541 267 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3152832 U
- JP 2008139070 A
- JP 2597858 B
- JP 2010038350 A